Europäisches Patentamt

**European Patent Office**

**Office européen des brevets**

(19)

(11) Publication number: **0 145 100**
A2

# (12) EUROPEAN PATENT APPLICATION

(21) Application number: **84201816.0**

(51) Int. Cl.⁴: **H 03 K 5/24**

(22) Date of filing: **06.12.84**

(30) Priority: **07.12.83 US 559164**

(43) Date of publication of application:
**19.06.85 Bulletin 85/25**

(84) Designated Contracting States:
**AT DE FR GB IT NL SE**

(71) Applicant: AMERICAN MICROSYSTEMS,
INCORPORATED
3800 Homestead Road
Santa Clara, CA 95051(US)

(72) Inventor: Haque, Yusuf A.
2052 Laddie Way
San Jose California 95121(US)

(74) Representative: Noz, Franciscus Xaverius, Ir. et al,
Boschdijk 155
NL-5612 HB Eindhoven(NL)

(54) Offset reduction for fast comparators employing series-connected, single-ended gain stages.

(57) A method of operation is provided for a fast comparator 10 which contains multiple series-connected, single-ended gain stages 113, 115, 117, 119). High resolution comparison is possible due to the reduction in offset by this method of operating the comparator. The offset of the first gain stage (113) is made to dissappear by placing it in an open loop mode prior to the turning on of the successive single-ended gain stages. The errors of successive single-ended gain stages are made to appear of less consequence because they are reduced by the inverse of the open loop gain of the upstream stage.

FIG. 1a

EP 0 145 100 A2

Croydon Printing Company Ltd.

-1-

# OFFSET REDUCTION FOR FAST COMPARATORS EMPLOYING SERIES-CONNECTED, SINGLE-ENDED GAIN STAGES

## BACKGROUND OF THE INVENTION

### Field of the Invention

This invention relates to a method of obtaining offset reduction for fast comparators and, more particularly, relates to a method for operating with reduced offset a comparator employing series-connected, single-ended gain stages.

### Description of the Prior Art

Offset voltage is an inherent characteristic of operational amplifiers. It results in nonsymmetrical operation about a zero reference voltage. It is circuit dependent and is produced by such factors as mismatch of components, spurious voltage couplings, etc. The value of the offset voltage for a given operational amplifier is essentially fixed but may drift with temperature and varies between operational amplifiers constructed in a similar manner. Offset is particularly critical and undesirable in operational amplifiers which are used as comparators. In comparators it is desired to determine when a voltage input, $V_{in}$, reaches the value of a reference voltage, $V_{ref}$. If the net offset of the comparator circuit is, e.g., 10 mV, the transition will occur 10 mV before or after $V_{ref}$ is reached. This introduces an error of 10 mV. This built-in error is intolerable for high resolution comparators.

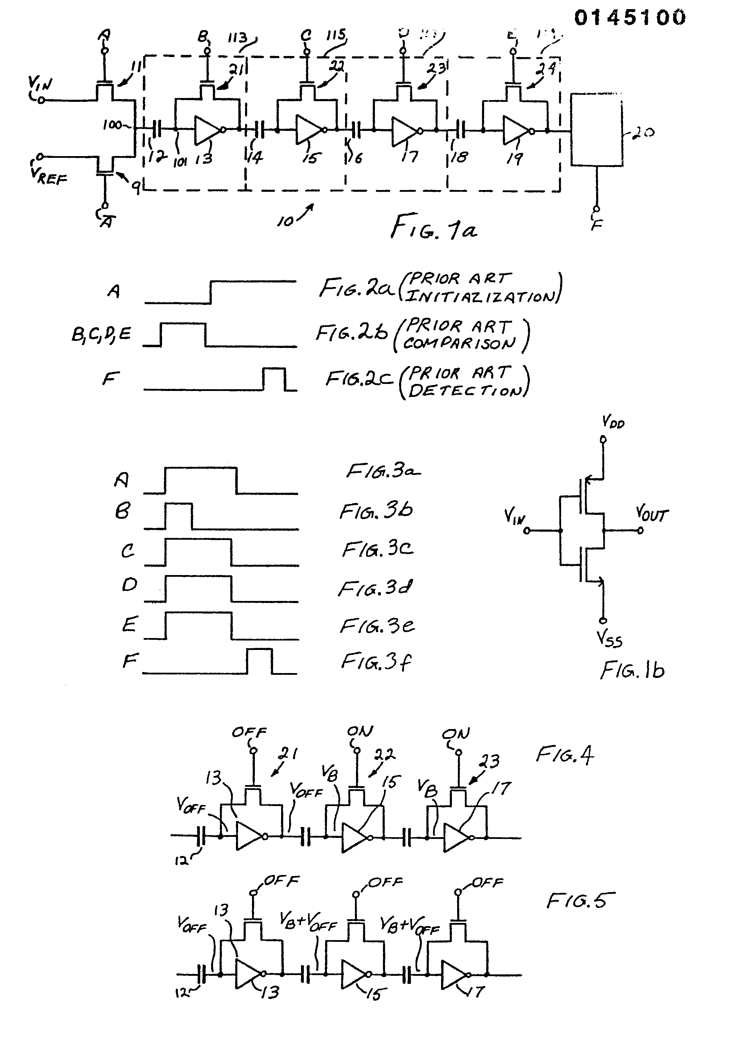

In order to assist in describing the Prior Art already is referred to Figs. 1a-1b and 2a-2c of the accompanying drawings, where: Fig. 1a is a schematic diagram of a comparator employing series-connected single-ended gain stages; Fig. 1b is a schematic diagram of a typical prior art CMOS inverter; and Figs. 2a-2c are the timing diagrams for the clocking signals of the prior art technique for utilizing the circuit of Fig. 1a.

One technique for reducing offset in a high resolution comparator is to build a comparator which uses a series of cascaded inverter stages. The structure of such a comparator is shown in Fig. 1a. This type of comparator and its conventional method of operation are described in S.W. Chin, et al., "Charge Balancing is Key to 10-bit A-D Converter Chip", Electronics, October 6, 1981, p. 136 and specification sheet, National Semiconductor ADD3500/ADD3501 3 1/2 Digit DVM With Multiplexed 7-Segment Output, which are hereby incorporated by reference. In operation, as the clocking signals A and $\bar{A}$ vary with time, the comparator circuit presents a differential voltage, $V_{in}$ minus $V_{ref}$, on node 100. Depending upon the relative values of $V_{in}$ and $V_{ref}$ this differential voltage, however small, will be positive or negative. The differential voltage is held on capacitor 12 and at an appropriate time is amplified by the successive inverter stages 13, 15, 17 and 19 so that the memory device 20 will hold a positive or negative voltage which will unequivocally signify a digital "one" or a digital "zero" depending upon the sign of the differential voltage $V_{in}-V_{ref}$. Memory device 20 is interrogated by signal F at an appropriate time in the cycle to obtain an output reading of the comparison. The deficiency with this circuit is that for each inverter stage there is an error charge presented at the input of the stage prior to amplification due to, for example, the voltage feedthrough from the clock to the input lead of the amplifying stages (through capacitance formed between the gate and the source/drain regions of the transistors 21-24). This error charge is amplified by succeeding stages and produces a significant cumulative error that can result in a false comparison. The most significant contribution to the cumulative error is made by the first gain stage (inverter 13, switching transistor 21) because the error is fully amplified by succeeding stages and because the impact of the offsets of subsequent gain stages are reduced by the gain provided by the first stage. In any event, the cumulative error prevents a high resolution comparison from being carried out.

It is therefore an object of the present invention to provide a method and structure for obtaining high resolution comparison using single-ended gain stages.

It is a further object of the present invention to provide a sequence of operation for a high resolution comparator employing single-ended gain stages whereby the first gain stage is made to appear free of offset error and subsequent gain stages have little impact on the comparison due to the reduction of their offset contribution by the open loop gain of the first stage.

It is another object of the present invention to provide a method of operating a comparator employing series-connected single-ended gain stages which turns the first stage on in advance of successive stages to null out the offset in the first stage.

## SUMMARY

A method of operation is provided for a fast comparator containing multiple series-connected single-ended gain stages. The offset voltage of the first gain stage is cancelled. This serves to reduce the offset of the succeeding gain stages by the open loop gain of the first stage. In other words, by cancelling the offset voltage of the first stage, the differential input voltage which will produce an output voltage of zero is brought much closer to zero, as desired.

In operation, the switching transistor of the first gain stage is turned off to activate the first inverter stage while the switching transistors of subsequent stages remain on so that the input leads of the inverters are being brought to their initial condition. This serves to eliminate the offset error of the first stage. Subsequently, when the remaining stages are operated to amplify the differential input signal their contributions to offset error are small because their errors are not amplified by the large open loop gain of the first stage (whose offset has already been eliminated). High resolution comparisons may thus be made between an input voltage and a reference voltage.

## BRIEF DESCRIPTION OF THE DRAWINGS

For a more complete understanding of the method and structure of the present invention reference may be had to the accompanying drawings which are incorporated herein by reference and in which:

Fig. 1a is a schematic diagram of a comparator employing series-connected single-ended gain stages;

Fig. 1b is a schematic diagram of a typical prior art CMOS inverter;

Figs. 2a-2c are the timing diagrams for the clocking signals of the prior art technique for utilizing the circuit of Fig. 1a;

Figs. 3a-3f are the timing diagrams for the operation of the circuit of Fig. 1 in accordance with the method of the present invention;

Fig. 4 is a schematic diagram of a portion of the circuit of Fig. 1a illustrating the interrelationship of the states of the first stage and subsequent stages in accordance with the method of the present invention; and

Fig. 5 is another partial schematic view of the

circuit of Fig. 1a illustrating the contribution o error charge to offset.

## DETAILED DESCRIPTION

Single-ended gain stage comparators are fast, have no common mode signal restrictions, require small areas when fabricated as a single or part of a larger integrated circuit device, and are inherently stable. However, offset voltage errors remain a problem. Previous attempts to reduce voltage offset have been ineffective because of the clock feedthrough problem as previously described. See, e.g., A. Dingwall, "Monolithic Expandable 6 Bit 20MHz CMOS/SOS A/D Converter", IEEE Journal of Solid State Circuits, December 1979, p. 926, which is hereby incorporated by reference.

The conventional operation of a comparator 10 having a succession of single-ended gain stages may be understood with reference to the circuit schematic of Fig. 1a in connection with the timing diagrams of Figs. 2a-2c. As shown in Fig. 2b the clocking signals B, C, D, and E are high to keep switching transistors 21-24 on so as to short the input leads with the output leads of the gain stages 113, 115, 117, and 119 (which include inverting amplifiers 13, 15, 17, 19, respectively) thereby to zero (reset) the stages before a comparison is made. During this time clocking signal A is low thus causing transistor switch 11 to turn off and transistor switch 9 to turn on, thus causing the reference voltage $V_{ref}$ is impressed on node 100 and capacitor 12.

Clocking signals B, C, D and E then go low thereby turning off switching transistors 21, 22, 23 and 24 and placing amplifiers 13, 15, 17 and 19 in an open loop mode. The collective gain of the series-connected single-ended gain stages is the product of the gain of each individual stage. Thus the cumulative gain $g_{Total}$ is $g_{13}$ x $g_{15}$ x $g_{17}$ x $g_{19}$ where $g_{13}$ is the gain of amplifier 13, $g_{15}$ is the gain of amplifier 15, $g_{17}$ is the gain of amplifier 17, and $g_{19}$ is the gain of amplifier 19. For each stage 113, 115, 117, 119 there is an offset error introduced by the spurious current and capacitive coupling between the gates and sources/drains of the switching transistor 21-24 as well as due to component mismatches within the inverters 13, 15, 17, 19. This offset appears as an error voltage on the input lead of each inverter 13, 15, 17, 19. The total input referred offset voltage of the comparator (i.e., the difference between the input voltage and the reference voltage which provides an output signal from the comparator signifying that the input voltage equals the reference voltage) has contributions from all the gain stages 113, 115, 117 and 119. However the offset contribution of later gain stages are reduced by the open loop gain of previous stages. Thus the first gain stage 113 is the most significant contributor to offset voltage.

As shown in Fig. 2a the clocking signal A then goes high to turn on input transistor 11 (and turn off transistor 9) so that the input voltage $V_{in}$ is presented at node 100. This charges capacitor 12 so that the voltage presented to the input lead of integrator 13 is the difference voltage, $V_{in}-V_{ref}$. The function of the comparator 10 is to produce the difference voltage $V_{in} - V_{ref}$ and amplify it so it can be detected. When the voltage $V_{in}$ is close to the reference voltage, $V_{ref}$, the difference voltage $V_{in}-V_{ref}$ will be small. It is desired that the change in polarity of the difference voltage, i.e., the crossover of $V_{in}$ and $V_{ref}$, be detected as soon as it occurs. It can be seen that the inclusion and amplification of the offset voltages will seriously impede the precise detection of the crossover of $V_{in}$ and $V_{ref}$. See S. W. Chin, et al., "Charge Balancing is Key to 10-Bit A-D Converter Chip", Electronics, October 6, 1981, p. 136, which is hereby incorporated by reference.

The present invention employs a unique method of sequencing the clock pulses of the switching transistors 21, 22, 23, 24 which results in error-free operation of the comparator. The presentation of the difference

voltage $V_{in}-V_{ref}$ on node 100 is performed in accordance with the above description. For each stage, when the clock controlling its switching transistor goes high, the switching transistor turn on thus shorting the inverter input and output leads, thereby resetting the gain stage; when the clock goes low the switching transistor turn off and the gain stage is ready for amplification. Amplification is provided by each stage. The gain of each amplifier is set by the geometry of the transistors used to form the gain stage, as is well known in the prior art. In one embodiment a CMOS gain stage consists of a p channel transistor and a n channel transistor as shown in Fig. 1b.

The method of the present invention may be understood with reference to Fig. 1a and the timing diagrams of Figs. 3a-3f. To initialize (reset) the comparator, clock signals A, B, C, D and E are initially high. During this initialization period the input voltage $V_{in}$ is impressed on node 100 via transistor 11. Simultaneously, initializing conditions are established on the inverters 13, 15, 17 and 19 (and thus gain stages 113, 115, 117, and 119) because transistors 21, 22, 23, 24 are turned on. The inverters 13, 15, 17, 19 are thus self-biased with a bias voltage $V_{B13}$, $V_{B15}$, $V_{B17}$, $V_{B19}$, respectively, appearing on their input and output leads. After initialization, the clocking signal B goes low thereby turning off the switching transistor 21 of the first stage 13 before the switching transistors of the succeeding stages turn off. The offset of the first stage is zeroed out, i.e., is made to disappear insofar as the succeeding series-connected single-ended gain stages are concerned since they are still in the reset mode. At this time, $V_{B13}+g_{13}\ V_{off1}$ is presented to the input lead of the second stage 115, where $V_{off1}$ is the offset voltage due to error charge which would appear on the input lead of inverter stage 113, $V_{B13}$ is the output voltage from inverter 13 during reset, and $g_{13}$ is the gain of the first stage. However, the second stage 115 cannot sense this voltage change (from $V_{B13}$ to $V_{B13+}\ g_{13}\ V_{off1}$) because

the second gain stage 115 is still being initialized. This may be seen in the partial schematic diagram of Fig. 4 where the gating signal B for switching transistor 21 is indicated to be off while the gating signals C, D for switching transistors 22 and 23 are on. At this time the voltage on the input leads of inverters 15 and 17 are $V_{B15}$ and $V_{B17}$, respectively, the self-bias voltages of the single-ended gain stage 115 and 117. For the first inverter stage 113, however, since transistor 21 is off, the voltage appearing on the input lead of inverter 13 is the offset voltage $V_{off1}$ having contributions from the leakage through transistor 21. Since the second inverter stage 115 is being initialized, however, the amplified output voltage $g_{13} V_{off1}$ which is presented to the second stage is nulled out insofar as inverter 15 is concerned, i.e., makes no contribution to the self-bias voltage $V_{B15}$. If, as in the prior art, the switching transistors 21, 22, 23, 24 of the first, second, third and fourth stages were turned off at the same time then the second stage would amplify $g_{13} V_{off1}$ by $g_{15}$ and the offset from the first stage would propagate through succeeding stages and produce a cumulative error. However, in accordance with the teachings of this invention, the switching transistors 21, 22, 23, 24 are not turned off simultaneously, thereby providing a comparator of significantly increased resolution as compared with comparators of the prior art.

Next, clock signals A, C, D and E go low (as shown in Figs. 3a-3f) so that switching transistors 22, 23 and 24 are turned off, and transistor 11 turns on (and transistor 9 turns off), thus connecting the input voltage $V_{in}$ to node 100. With switches 21, 22, 23 and 24 turned off, the gain stages 113, 115, 117 and 119 are ready to amplify the voltage changes presented to their input leads. The voltage change $V_{ref}-V_{in}$ is impressed on node 100 by clock A going low. Amplifier 13 amplifies this signal and presents a signal change signal to $\alpha g_{13}$ $(V_{ref}-V_{in})$ to the input lead of the second stage 15,

where $\alpha$ is the attenuation through capacitor 12. The second stage 15 only amplifies input voltage changes with respect to its input voltage immediately after clock C goes low. In this case this voltage is

$$g_{13}V_{off1}+V_{B13} \qquad (1)$$

When node 100 is connected to $V_{in}$, the voltage change $V_{in}-V_{ref}$ is presented to the first stage 113. Thus the final output voltage of the first stage 113 is

$$g_{13}V_{off1}+V_{B13}+\alpha(V_{in}-V_{ref})g_{13} \qquad (2)$$

The second stage amplifies the difference voltage between equations (1) and (2), i.e., $\alpha(V_{ref}-V_{in})g_{13}$. Of importance, this is free of first stage offset error $V_{off13}$. The second stage 15 now amplifies $\alpha(V_{in}-V_{ref})g_{13}$ with offset error $V_{off15}$ from stage 15 only. Similarly, stages 17 and 19 amplify the input differential signal, together with offset voltages from preceeding stages other than stage 13. However, when the output error is referred back to the input of comparator 10 (offset voltages are always input referred), they are reduced by the gain of the first stage and are no longer significant. In other words, the input voltage which will provide an output signal indicating that $V_{in}=V_{ref}$ will be made closer to $V_{ref}$ as compared with prior art comparators. For example, using the prior art clock switching technique (clocks B, C, D, and E go low simultaneously), an input offset error voltage $V_{inoff}$ is present such that an input voltage $(V_{ref}+V_{inoff})$ is required to provide an output signal indicating that the input voltage equals the referred $V_{ref}$. Using the clock switching technique of this method, the input offset error is reduced by the gain $g_{13}$ of the first inverter 13. Thus, in accordance with this invention, an input voltage $(V_{ref}+V_{inoff}/g_{13})$ is required to provide an output signal indicating that this allowsmuch more accurate voltage comparisons to be made than was allowed using prior art comparators.

There are two features of the method of the present invention which produce the reduction of offset. First, since the timing signal on the switching transistor of the first stage 113 or another upstream stage is low while both the input transistor 11 and the switching transistors of succeeding gain stages are on, the first stage is made to appear error free. Any leakage current or any circuit-based offset is amplified through the first stage and cancelled out in the closed loop succeeding gain stages. Referring to Figs. 4 and 5, when clock signal B goes low, the output voltage of inverter 13 is $V_{B13} + g13\ V_{off13}$, where $V_{off13}$ is the net change in voltage at node b due to clock signal B going low. The voltage $V_{B13}$ appears because that is the initializing voltage. Next, when clock A goes low, node 100 changes by $V_{in} - V_{ref}$. This causes a change $\alpha(V_{in} - V_{ref})$ on node 101. Thus, the total output voltage of inverter 13 is $V_{B13} + g_{13}V_{off13} + \alpha(V_{in} - V_{ref})g_{13}$. Thus the change in output voltage of inverter 13 is

$$V_{B13} + g_{13}\ V_{off1} + \alpha g_{13}\ (V_{in} - V_{ref}) - V_{B13} + g_{13}\ V_{off13} =$$
$$\alpha g_{13}\ (V_{in} - V_{ref})$$

where     $V_{B13}$ = self-bias voltage on first gain stage 13

$V_{off13}$ = offset voltage for first gain stage

$g_{13}$ = gain of first stage

$V_{in}$ = input voltage

$V_{ref}$ = reference voltage

$\alpha$ = attenuation through input capacitor 12.

Thus, it can be seen that as the comparison of the input voltage $V_{in}$ takes place, i.e., when the difference voltage $V_{in} - V_{ref}$ is amplified, there is no contribution of an offset error from the first stage 113 but only an amplification of the potential difference $V_{in} - V_{ref}$. Thus there is no offset voltage error from the first stage 113 to be multiplied by successive stages 115, 117, 119. The second feature that reduces offset for the method of the present invention is that the errors which will be present in the succeeding stages 15, 17 and 19 will not have a significant impact on the final result since the offset of any stage is reduced by the open loop gain of the preceding stage. Thus, the effective offset (referred to the input) of the second stage 115 is given by $V_{off15}/g_{13}$ where $V_{off15}$ is the offset of inverter 15 and thus of the second gain stage 115. This same principle applies to the offset of inverter 17 where the effective offset is $V_{off19}/g_{13}g_{15}$ where $V_{off17}$ is offset of the third gain stage 17 and for inverter 19 where the effective offset is $V_{off19}/g_{13}g_{15}g_{17}$ where $V_{off19}$ is the offset of the fourth gain stage 19. Thus, even though there will be offsets for these succeeding stages, the offsets will have minimal impact on the overall comparison of the input voltage $V_{in}$ with reference voltage $V_{ref}$.

The method of the present invention has been described in connection with the preferred embodiment in which the first gain stage is placed in an open loop mode in advance of the remaining stages. Additional advantages of a lesser order still accrue if any stages before the final stage are placed in an open loop mode ahead of the following stages. For example, in one embodiment of the present invention, clocking pulse C turned switching transistor 22 off in advance of clocking pulses D and E.

The specific embodiments of this invention described in this specification are intended to serve by way of example and are not a limitation on the scope of my invention. Numerous other embodiments of this invention will become apparent to those of ordinary skill in the art in light of the teachings of this specification.

The figures used in the claims are only meant to explain more clearly the intention of the invention and are not supposed to be any restriction concerning the interpretation of the invention.

-1-

CLAIMS

I claim:

1.  A method of operating a comparator having multiple series-connected single-ended gain stages wherein each stage comprises an inverter having an input lead and an output lead, and a switch means connected between said input and output leads of said inverter, comprising the steps of:

applying a signal representative of the difference between an input voltage and a reference voltage to the input lead of the first of said single-ended gain stages;

closing said switch means;

opening said switch means connected between said input and output leads of at least one of said single-ended gain stages, said at least one single ended gain stage being placed in an open loop amplifying mode whereby the offset voltages appearing on the input lead of said single-ended gain stage are amplified through said stage and nulled out by said succeeding stages which remain in a closed loop zeroing mode; and

opening said switch means connected between said input and output leads of gain stages which precede and succeed said at least one single ended gain stage so that said series-connected single-ended gain stages will operate as a comparator.

2. A method of operating a comparator, as set out in Claim 1, wherein said at least one of said single-ended gain stage is the first single ended gain stage.

3. A method of operating a comparator in accordance with Claim 1 in combination with the step of evaluating the output signal from the final stage of said single-ended gain stages.

4. A method of operating a comparator in accordance with Claim 1 in combination with the step of applying said reference voltage to the input lead of said first single-ended gain stage prior to the step of opening said switch means connected between the input and output leads of said one or more single-ended gain stages.

5. A method of operating a comparator in accordance with Claim 1 in combination with the step of applying an input voltage to the input lead of said first single-ended gain stage prior to said step of opening said switch means connected between said input and output leads of gain stages which precede and succeed said single-ended gain stage.

6. The method as in Claim 1 wherein each said switch means comprises a transistor.

7. The method as in Claim 6 wherein said transistor is an MOS transistor.

8. The method as in Claim 1 wherein each said single-ended gain stage further comprises a capacitor having a first plat connected to said input lead of said inverter and having a second plate serving as the input lead of said comparator.

0145100

Fig. 1a

A $V_{IN}$ $V_{REF}$ $\overline{A}$ B C D E 11 21 22 23 24 100 101 12 13 14 15 16 17 18 19 20 10 F 113 115

Fig. 2a (PRIOR ART INITIALIZATION)
A

Fig. 2b (PRIOR ART COMPARISON)
B, C, D, E

Fig. 2c (PRIOR ART DETECTION)
F

Fig. 3a — A
Fig. 3b — B
Fig. 3c — C
Fig. 3d — D
Fig. 3e — E
Fig. 3f — F

Fig. 1b
$V_{DD}$ $V_{IN}$ $V_{OUT}$ $V_{SS}$

Fig. 4
OFF ON ON
13 $V_{OFF}$ $V_B$ $V_B$ 21 22 23 15 17 12 $V_{OFF}$

Fig. 5
OFF OFF OFF
$V_{OFF}$ 13 $V_B+V_{OFF}$ $V_B+V_{OFF}$ 12 13 15 17